# EUROPEAN PATENT APPLICATION

(11) **EP 2 086 113 A2**
(43) Date of publication of application: **05.08.2009**
(21) Application number: 09000530.7
(22) Date of filing: 15.01.2009
(51) Int. Cl.: H03K 17/95

(54) **Swing type switching device including magnet and magnetoresistive element**

(30) Priority: 04.02.2008 JP 2008024043
(71) Applicant: Alps Electric Co., Ltd., Tokyo 145-8501 (JP)
(72) Inventor: Kikuchi, Yuya, Tokyo 145-8501 (JP)
(74) Representative: Klunker . Schmitt-Nilson . Hirsch

(57) **Abstract**

To provide a swing type switching device which includes: an operation body (3) which can swing and automatically returns to a neutral posture during a non-operation; a permanent magnet (4) which moves along a predetermined plane by being interlocked with the operation body (3) and is positioned at a neutral position during the non-operation of the operation body (3); and a magnetoresistive element (5) of which the electrical resistance is changed in accordance with the change of a magnetic field that is caused by the movement of the permanent magnet (4). An operation position of the operation body (3) can be detected on the basis of the change of the resistance of the magnetoresistive element (5), and the permanent magnet (4) is magnetized so that pole faces (4a, 4b) thereof extend along the predetermined plane, and the magnetoresistive element (5) is formed in a plane that is substantially orthogonal to a height direction of the permanent magnet (4) positioned at the neutral position, and one pole face of the permanent magnet (4) is close to and faces a side portion of the magnetoresistive element (5) at the neutral position.

## Description

### Cross Reference to Related Application

The present invention contains subject matter related to Japanese Patent Application No. 2008-024043 filed in the Japanese Patent Office on February 04, 2008, the entire contents of which being incorporated herein by reference.

### BACKGROUND

### 1. Field of the Invention

The present invention relates to a swing type switching device for performing a switching operation by the swing of an operation body, such as a switching device for a power window of a vehicle, and particularly to, a swing type switching device that uses a magnetism detecting method.

### 2. Description of the Related Art

Generally, a swing type switching device such as a switching device for a power window has a structure in which, if an operation body swings, a movable contact and a fixed contact come into contact with or separate from each other to perform the switching. However, the swing type switching device of this type has a disadvantage in that it is difficult to maintain high reliability over a long period of time because there is a concern that dust and the like adheres to the contacts or the contacts are worn or oxidized.

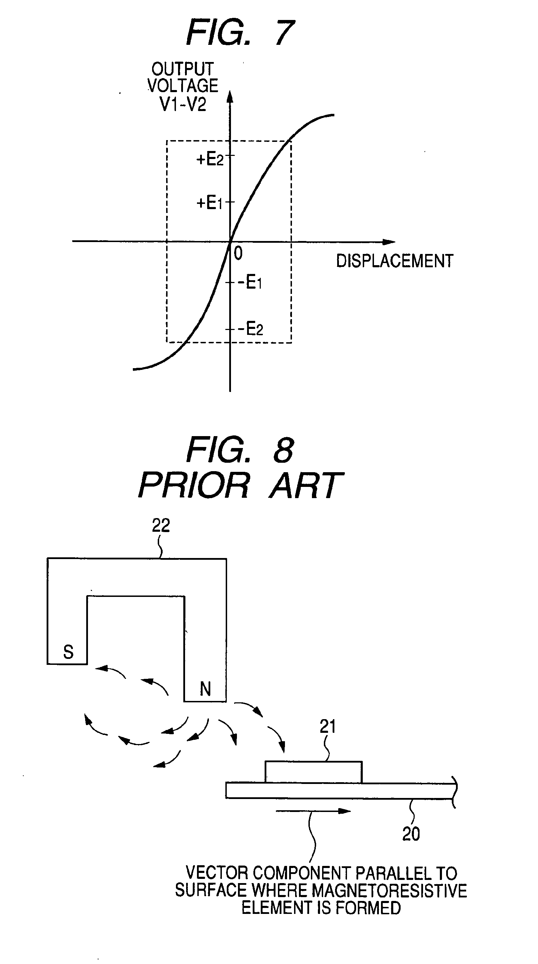

In view of this, in the past, Japanese Patent No. 3783271 has proposed a swing type switching device that uses a magnetism detecting method and includes a permanent magnet which swings by being interlocked with an operation body and a magnetoresistive element of which the electrical resistance is changed in accordance with the change of a magnetic field that is caused by the movement of the permanent magnet. In the conventional switching device, as shown in Fig. 8, a magnetoresistive sensor 21 including a magnetoresistive element, that is, a magnetoresistance element (MRE) incorporated therein is mounted on a circuit board 20. In addition, a permanent magnet 22 swings along a plane parallel to the page of Fig. 8 by being interlocked with an operation body (not shown) in the vicinity of the magnetoresistive sensor 21. In Fig. 8, arrows indicate magnetic field vectors of the permanent magnet 22 and the magnetic field vectors pass through a forming surface where the magnetoresistive element is formed in the magnetoresistive sensor 21. Accordingly, if the permanent magnet 22 moves due to the swing of the operation body, the electrical resistance of the magnetoresistive element is changed in accordance with the direction or strength of the magnetic field vectors, and as a result, the output voltage of the magnetoresistive sensor 21 is changed. Therefore, the operation position of the operation body can be detected on the basis of the output of the magnetoresistive sensor 21 during the swing of the operation body and the movable contact and the fixed contact are not necessary to come into contact with or separate from each other. Accordingly, it is possible to prevent the reduction of reliability that is caused by the adherence of dust and the like or the wearing or oxidation of the contacts.

In the swing type switching device such as a switching device for a power window, the operation body automatically returns to a neutral posture during a non-operation and thus the permanent magnet 22 is positioned at a neutral position during the non-operation to be closest to the magnetoresistive sensor 21.

In the conventional swing type switching device shown in Fig. 8, the magnetoresistive element reacts to the vector components parallel to the forming surface among the magnetic field vectors of the permanent magnet 22 passing through the forming surface where the magnetoresistive element is formed in the magnetoresistive sensor 21. When the permanent magnet 22 is positioned at the neutral position during the non-operation of the operation body, a magnetic field of the permanent magnet 22 applied to the magnetoresistive element becomes the strongest. However, at the neutral position, the magnetic field vectors of the permanent magnet 22 pass through at a tilt the forming surface where the magnetoresistive element is formed. In addition, the vector components perpendicular to the forming surface largely exist and the vector components parallel to the forming surface are few. Accordingly, there is a concern that the magnetic field of the permanent magnet 22 acting on the output of the magnetoresistive element becomes undesirably weak. Meanwhile, when the switch is used to perform open and close operations of the power window, the operation body is operated for a short period of time for the open and close operations. Most of the time, the operation body is not operated and thus is commonly positioned at the neutral position. Accordingly, in the above-described conventional example, problems occur in that reliability is reduced due to a high probability of being affected by magnetic noise or component cost increases due to the use of a special permanent magnet having a strong magnetic force. When the parallel vector components are few at the neutral position, the same problem occurs even at a different position to which the permanent magnet moves from the neutral position.

### SUMMARY

The invention is contrived in view of the conditions of the conventional technique and an object of the invention is to provide a swing type switching device that uses a magnetism detecting method and has high reliability with easily suppressed component cost.

In order to achieve the object, the invention provides a swing type switching device which includes: an operation body which can swing and automatically returns to a neutral posture during a non-operation; a permanent magnet which moves along a predetermined plane by being interlocked with the operation body and is positioned at a neutral position during the non-operation of the operation body; and a magnetoresistive element of which the electrical resistance is changed in accordance with the change of a magnetic field that is caused by the movement of the permanent magnet. An operation position of the operation body can be detected on the basis of the change of the resistance of the magnetoresistive element. The permanent magnet is magnetized so that pole faces thereof extend along the predetermined plane, and the magnetoresistive element is formed in a plane that is substantially orthogonal to a height direction of the permanent magnet positioned at the neutral position, and one pole face of the permanent magnet is close to and faces a side portion of the magnetoresistive element at the neutral position.

In the swing type switching device having the above-described structure, when the permanent magnet is positioned at the neutral position in the non-operation state of the operation body, the direction of the magnetic field vectors of the permanent magnet passing through the forming surface where the magnetoresistive element is formed is substantially parallel to the forming surface and the vector components perpendicular to the forming surface where the magnetoresistive element is formed are very few. Accordingly, even when the permanent magnet has a normal magnetic force, it is possible to apply a strong magnetic field to the magnetoresistive element. Thus, it is possible to prevent the influence of magnetic noise in the non-operation state corresponding to the highest frequency of the positioning. Further, in the case where the above structure is employed, even when the permanent magnet moves from the neutral position through the swing of the operation body, a movement range of the permanent magnet is easily defined so that the height direction of the permanent magnet is not largely tilted with respect to the forming surface where the magnetoresistive element is formed. In this manner, a magnetic field in which the number of the vector components parallel to the forming surface where the magnetoresistive element is formed is large can be applied to the magnetoresistive element. Accordingly, it is possible to always efficiently apply the magnetic field of the permanent magnet to the magnetoresistive element and thus the change of the magnetic field that is caused by the movement of the permanent magnet can be easily and accurately detected by the magnetoresistive element. Thus, the switching device is rarely affected by the magnetic noise and its reliability is improved.

In the above-described structure, if the permanent magnet swings along the predetermined plane by being interlocked with the operation body, it is preferable because it is possible to obtain the swing type switching device having a simplified structure in which the permanent magnet is integrally formed with the operation body. In this case, if a swingable angle range of the permanent magnet is defined so that a plane extended from the forming surface where the magnetoresistive element is formed always crosses one pole face of the permanent magnet, the permanent magnet can swing so that the height direction of the permanent magnet is not largely tilted with respect to the forming surface where the magnetoresistive element is formed. Accordingly, there is no concern that the vector components, which are perpendicular to the forming surface, among the magnetic field vectors of the permanent magnet passing through the forming surface where the magnetoresistive element is formed are undesirably increased, and it is possible to always efficiently apply the magnetic field of the permanent magnet to the magnetoresistive element. In this case, if a swingable angle range of the permanent magnet is defined so that the magnetoresistive element is positioned within the height range of the permanent magnet, the parallel magnetic field of the permanent magnet is applied to the magnetoresistive element and it is possible to always efficiently apply the magnetic field of the permanent magnet to the magnetoresistive element. The permanent magnet may move by being driven by the operation body during the swing thereof. In this case, the permanent magnet may be driven by the operation body and slide in a straight line.

In addition, in the above-described structure, the magnetoresistive element may be an anisotropic magnetoresistance (AMR) element. However, if the magnetoresistive element is a giant magnetoresistance (GMR) element, it is more preferable because the change of the direction of the magnetic field that is caused by the movement of the permanent magnet can be accurately detected by the GMR element. The magnetoresistive element also may be a tunnel magnetoresistance (TMR) element.

According to the swing type switching device of the invention, when the permanent magnet is positioned at the neutral position in the non-operation state of the operation body, the direction of the magnetic field vectors of the permanent magnet passing through the forming surface where the magnetoresistive element is formed is substantially parallel to the forming surface. Accordingly, even when the permanent magnet has a normal magnetic force, it is possible to apply a strong magnetic field to the magnetoresistive element. Thus, it is possible to prevent the influence of magnetic noise in the non-operation state corresponding to the highest frequency of the positioning. Further, in the case where the above structure is employed, even when the permanent magnet moves from the neutral position through the swing of the operation body, a movement range of the permanent magnet can be easily defined so that the height direction of the permanent magnet is not largely tilted with respect to the forming surface where the magnetoresistive element is formed. In this manner, a magnetic field in which the number of the vector components parallel to the forming surface where the magnetoresistive element is formed is large can be applied to the magnetoresistive element. Accordingly, it is possible to always efficiently apply the magnetic field of the permanent magnet to the magnetoresistive element and thus the change of the magnetic field that is caused by the movement of the permanent magnet can be easily and accurately detected by the magnetoresistive element and there is no need to use a special permanent magnet having a strong magnetic force. Thus, it is possible to provide a swing type switching device that uses a magnetism detecting method, is rarely affected by magnetic noise, and has high reliability with easily suppressed component cost.

### BRIEF DESCRIPTION OF THE DRAWINGS

Fig. 1 is an exploded perspective view of a swing type switching device according to an embodiment of the invention;
Fig. 2 is an explanatory diagram showing the inner structure of the switching device according to the embodiment;
Fig. 3 is an explanatory diagram showing a relative positional relationship between a permanent magnet and a GMR sensor of the embodiment;
Fig. 4 is a characteristic diagram showing magnetic field vectors of the permanent magnet of the embodiment;
Fig. 5 is an explanatory diagram showing a neutral position and a maximum displacement position of the permanent magnet of the embodiment;
Fig. 6 is a circuit diagram of the GMR sensor of the embodiment;
Fig. 7 is a characteristic diagram showing a relationship between the displacement of the permanent magnet and the output voltage of the GMR sensor of the embodiment; and
Fig. 8 is an explanatory diagram showing problems in the related art.

### DESCRIPTION OF EXEMPLARY EMBODIMENTS

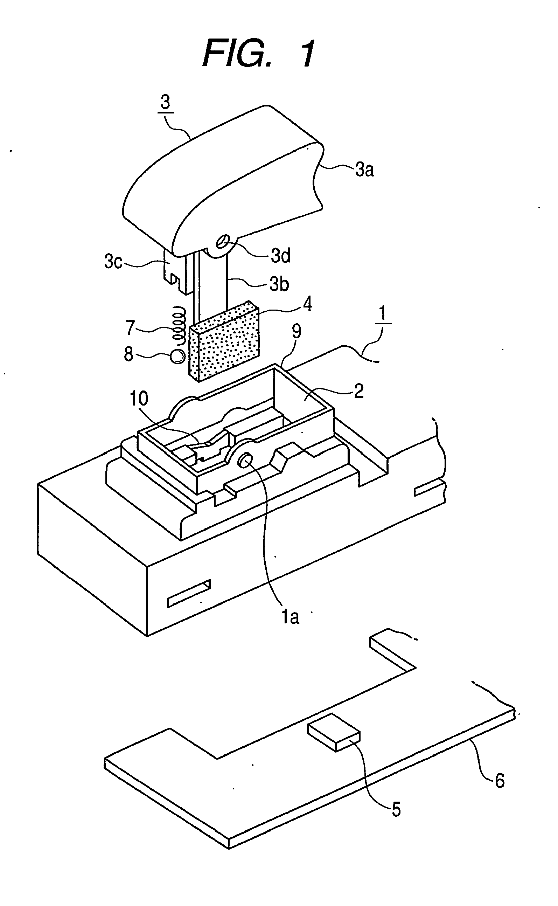

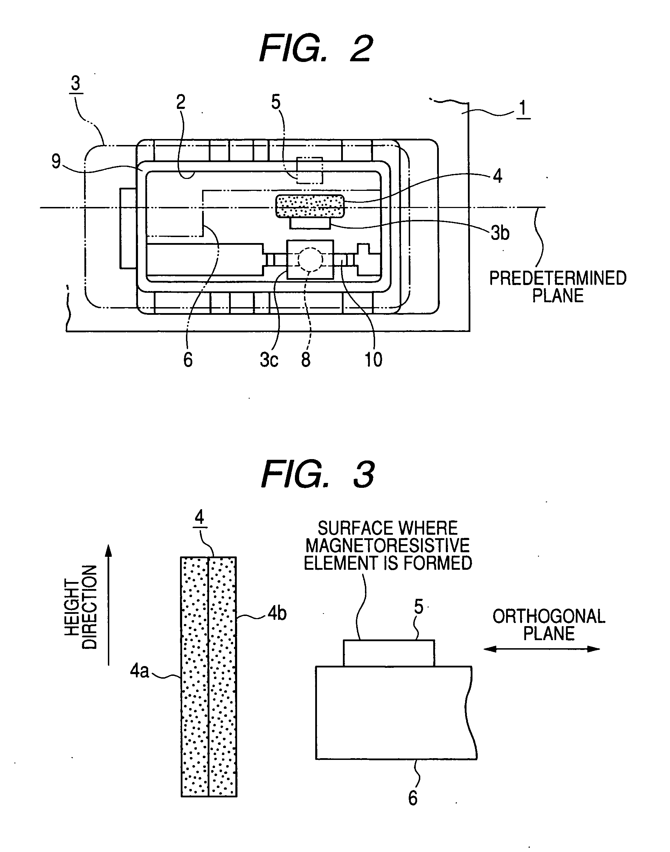

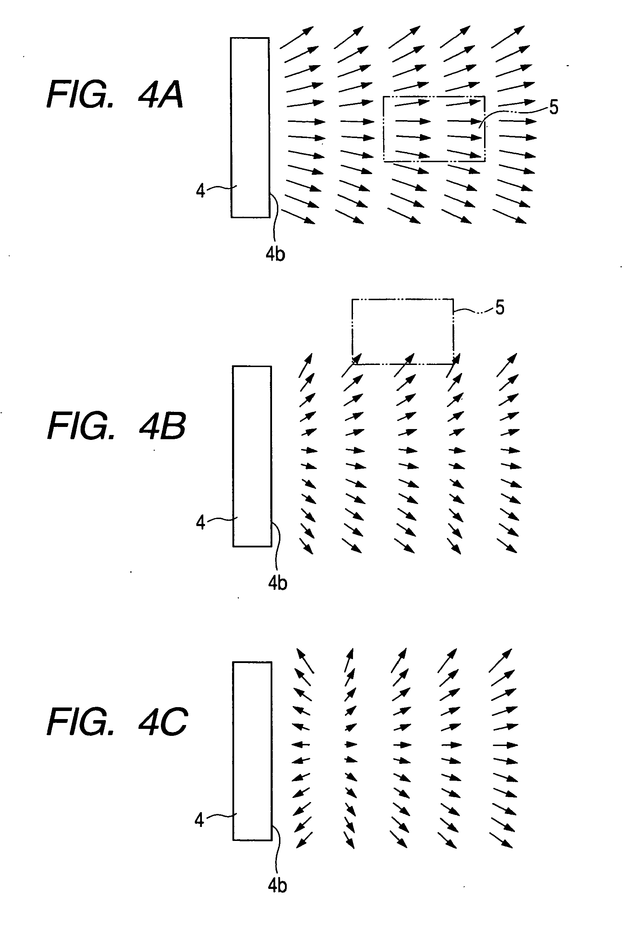

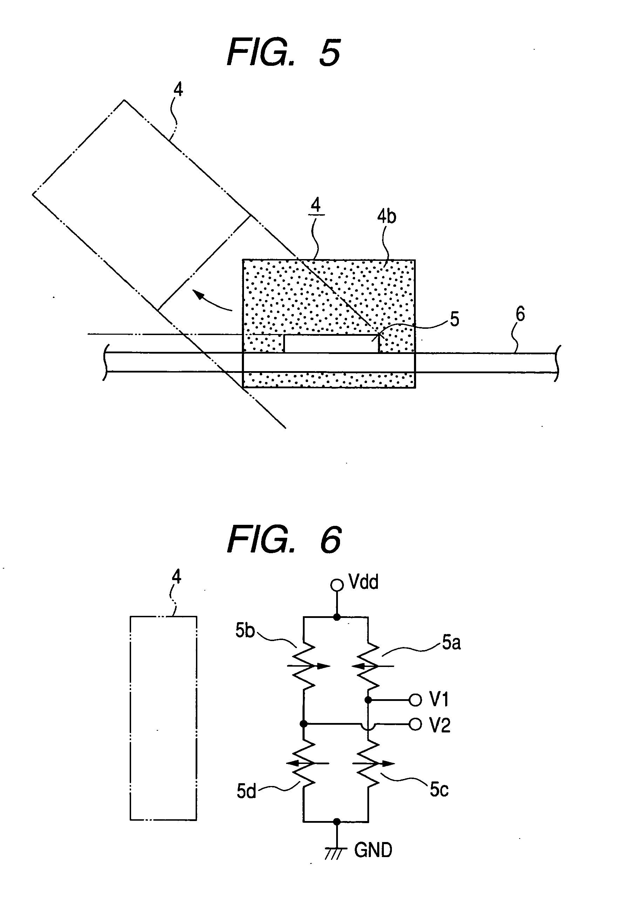

An embodiment of the invention will be described with reference to drawings. Fig. 1 is an exploded perspective view of a swing type switching device according to an embodiment of the invention. Fig. 2 is an explanatory diagram showing the inner structure of the switching device. Fig. 3 is an explanatory diagram showing a relative positional relationship between a permanent magnet and a GMR sensor of the embodiment. Fig. 4 is a characteristic diagram showing magnetic field vectors of the permanent magnet of the embodiment. Fig. 5 is an explanatory diagram showing a neutral position and a maximum displacement position of the permanent magnet of the embodiment. Fig. 6 is a circuit diagram of the GMR sensor of the embodiment. Fig. 7 is a characteristic diagram showing a relationship between the displacement of the permanent magnet and the output voltage of the GMR sensor of the embodiment.

A switching device shown in Figs. 1 and 2 is a swing type switching device that uses a magnetism detecting method and is used as a switching device for a power window of a vehicle. The switching device generally includes a case 1 having an opening 2, an operation body 3 that is swingably attached to the case 1, a plate-like permanent magnet 4 that is fixed to a suspended piece 3b of the operation body 3 and moves along a predetermined plane orthogonal to a rotation axis of the operation body, a printed board 6 on which the GMR sensor 5 is mounted and which is provided in the case 1, and a spring 7 and a spherical body 8 that are received in the suspended box portion 3c of the operation body 3.

A standing wall 9 is integrally formed with the case 1 to surround the opening 2, and pivots 1a protrude from the outer surface of the standing wall 9 at two positions of the standing wall. Further, a substantially V-shaped cam face 10 for click, which is exposed to the inside of the opening 2, is formed in the case 1. The spherical body 8, which can move upward and downward in the suspended box portion 3c of the operation body 3, is elastically pushed against a spring 7, thereby always coming in elastic contact with the cam face 10 for click.

The operation body 3 has a shape where the suspended piece 3b and the suspended box portion 3c protrude downward from a ceiling portion of the operating knob 3a, and bores 3d are formed through both side walls of the operating knob 3a. The pivots 1a corresponding to a pair of the bores 3d are snap-fitted to the bores, respectively, so that the operation body 3 is swingably attached to the case 1 to close the opening 2. Further, since the spherical body 8 elastically pushed against the spring 7 is engaged with a valley portion of the cam face 10 for click during a non-operation, the operation body 3 is held at a neutral posture. The operation body 3 can swing about the pivots 1a as a rotation axis due to the application of an operating force that is against a reaction force of the spring 7. If the operation body 3 swings, the suspended box portion 3c is tilted, so that the spherical body 8 moves along the cam face 10 for click. Furthermore, if the operating force is removed from the swinging operation body 3, the spherical body 8 moves along the cam face 10 for click by the reaction force of the spring 7 and engaged with the valley portion of the cam face 10 again. Accordingly, the operation body 3 automatically returns to the neutral posture.

The permanent magnet 4 is a body that has the shape of a square plate having, for example, a length of 6 mm, a width of 6 mm, and a thickness of 1 mm. The permanent magnet is magnetized so that both end faces thereof in a thickness direction become pole faces 4a and 4b as shown in Fig. 3. That is, the permanent magnet 4 is magnetized so that the flat portion (pole face 4a) fixed to the suspended piece 3b corresponds to an S pole and an opposite flat portion (pole face 4b) corresponds to an N pole. Magnetic field vectors of the permanent magnet 4 magnetized as described above are the same as shown in Fig. 4A in a plane that has the same height and gets across the central portion of the permanent magnet. Meanwhile, Fig. 4B shows magnetic field vectors in a plane that has the same height and includes an upper end face (or lower end face) of the permanent magnet 4. Fig. 4C shows magnetic field vectors in a plane that has the same height and includes an upper (or lower) portion of the permanent magnet 4 corresponding to a distance of 3 mm, and shows magnetic field vectors at a portion that does not face the permanent magnet 4. That is, it is understood that the magnetic field is large in the range corresponding to a height direction of the permanent magnet 4 but is decreased because a portion where the direction of the magnetic field is reversed is formed at a position that deviates from the height direction. Further, since the suspended piece 3b is not tilted during the non-operation of the operation body 3, the permanent magnet 4 is positioned at a neutral position shown by a solid line in Fig. 5. In this state, the permanent magnet 4 is positioned so that the middle portion of one pole face 4b is close to and faces a side portion of the GMR sensor 5 (see Fig. 3). Furthermore, since the suspended piece 3b is tilted when the operation body 3 swings, the permanent magnet 4 moves so that the pole faces 4a and 4b thereof are parallel to a predetermined plane. For example, the permanent magnet swings (moves a circular-arc shape) up to a position that is shown by a two-dot chain line in Fig. 5. Meanwhile, the swing of the permanent magnet 4 is performed along a plane parallel to the page of Fig. 5 (a plane orthogonal to the page of Fig. 3), and the pole faces 4a and 4b of the permanent magnet 4 extend along the plane.

The GMR sensor 5 is formed by forming giant magnetoresistance elements (hereinafter, referred to as GMR elements) on a substrate and packaging them. The electrical resistance of the GMR element is changed in accordance with the change of a magnetic field that is caused by the movement of the permanent magnet 4. The GMR element is a magnetoresistive element having a structure in which a fixed magnetization layer and a free magnetization layer are laminated with a nonmagnetic intermediate layer interposed therebetween. If an external magnetic field is changed in a plane parallel to a laminate surface (forming surface), the magnetization direction of the free magnetization layer is changed. As shown in Fig. 6, the GMR sensor 5 includes four GMR elements 5a to 5d having the same characteristics. The GMR elements are disposed and connected to each other to form a bridge circuit so that the magnetization directions of the fixed magnetization layers of the GMR elements 5a and 5d face the same direction and the magnetization directions of the fixed magnetization layers of the GMR elements 5b and 5c face the opposite direction. As shown in Figs. 3 and 5, the GMR sensor 5 is mounted on the printed board 6 so as to satisfy a positional relationship where the middle portion of the pole face 4b faces the side surface of the GMR sensor 5 when the permanent magnet 4 is positioned at the neutral position. Further, the GMR elements 5a to 5d are formed in a plane that is substantially orthogonal to the height direction of the permanent magnet 4 positioned at the neutral position (a plane that is substantially parallel to the printed board 6). Arrows shown in Fig. 6 indicate the magnetization directions of the fixed magnetization layers of the GMR elements 5a to 5d, and the magnetization directions of the fixed magnetization layers are set perpendicular to the pole faces 4a and 4b of the permanent magnet 4 positioned at the neutral position. The electrical resistance of each of the GMR elements 5a to 5d is changed in accordance with the change of a magnetic field that is caused by the movement of the permanent magnet 4. Accordingly, while a predetermined voltage Vdd is applied to the GMR sensor 5, an output voltage (V1-V2) is changed as shown in Fig. 7 in accordance with the displacement (swing position) of the permanent magnet 4. Meanwhile, a position corresponding to a displacement of 0 on a horizontal axis of Fig. 7 corresponds to a state in which the permanent magnet 4 is positioned at the neutral position. Accordingly, the displacement of the permanent magnet 4 corresponding to the swing position of the operation body 3 can be detected on the basis of the output voltage that corresponds to a portion that is close to a straight line surrounded by a broken line in Fig. 7, so that it is possible to perform the switching at the points when the output voltages (±E1 and +E2) corresponding to a plurality of swing positions of the operation body 3 are detected.

That is, in the non-operation state in which the operation body 3 does not swing, the permanent magnet 4 is positioned at the neutral position shown by a solid line in Fig. 5 and the largest magnetic field is applied to the GMR sensor 5. In this case, the magnetization direction of the free magnetization layer of each of the GMR elements 5a to 5d of the GMR sensor 5 is parallel to the magnetization direction of the fixed magnetization layer. Accordingly, the electrical resistance of each of the GMR elements 5a to 5d is the same as that when a magnetic field is not applied, and the resistance values are the same as each other when the magnetic field is not applied. Therefore, the output voltage of the GMR sensor 5 becomes a supply voltage. Further, the neutral position corresponds to a state in which the operation body 3 is not operated, and the frequency corresponding to the neutral position is the highest. However, even though noise or the like enters from the outside in this state so that an undesired magnetic field component is applied to the GMR sensor 5, a relatively large magnetic field is applied to the GMR sensor. Accordingly, it is possible to reduce the influence of the noise, thereby reducing the possibility of malfunction. Then, if the permanent magnet 4 moves to the right or left side of Fig. 6 through the swing of the operation body 3, the direction of the magnetic field of the permanent magnet 4 with respect to each of the GMR elements 5a to 5d is gradually tilted. Accordingly, the electrical resistance of each of the GMR elements 5a to 5d is changed in accordance with the magnetization direction of the fixed magnetization layer. As a result, the output voltage of the GMR sensor 5 is changed into a predetermined negative or positive value. For example, if the operation body 3 is rotated from the neutral posture in a clockwise direction by a predetermined angle, an output voltage is changed from an applied voltage to +E1 due to the movement of the permanent magnet 4. If the operation body 3 is further rotated in the same direction as described above by a predetermined angle, the output voltage is changed to +E2 due to the movement of the permanent magnet 4. Likewise, if the operation body 3 is rotated from the neutral posture in a counterclockwise direction by a predetermined angle, the output voltage is changed from an applied voltage to -E1. If the operation body 3 is further rotated in the same direction as described above by a predetermined angle, the output voltage is changed to -E2.

Further, in this embodiment, a swingable angle range of the permanent magnet 4 is defined so that a plane extended from a forming surface where the GMR elements 5a to 5d are formed always crosses the pole face 4b of the permanent magnet 4. The permanent magnet 4, which is shown by a two-dot chain line in Fig. 5, corresponds to a state in which the permanent magnet moves from the neutral position to the maximum extent in one direction. A state in which the permanent magnet 4 moves from the neutral position to the maximum extent in the other direction is not shown, but corresponds to a position axisymmetric to the position that is shown by the two-dot chain line position. Further, even when the permanent magnet 4 is positioned at the position shown by the two-dot chain line in Fig. 5 and a swing angle thereof is maximum, there is no concern that vector components, which are perpendicular to the forming surface, among the magnetic field vectors of the permanent magnet 4 passing through a forming surface where the GMR sensor 5 is formed are undesirably increased, and it is possible to always efficiently apply the magnetic field of the permanent magnet 4 to the GMR sensor 5. That is, if the permanent magnet 4 further largely swings from the position shown by the two-dot chain line in Fig. 5, the vector components of the permanent magnet 4 of which the directions correspond to the direction of the forming surface where the GMR elements are formed are decreased, so that the switching device is easily affected by noise. Further, even when the permanent magnet 4 is positioned at the position shown by the two-dot chain line in Fig. 5 and the swing angle thereof is maximum, a swingable angle range of the permanent magnet 4 is defined so that the GMR sensor 5 is positioned within a height range of the permanent magnet 4. For this reason, the magnetic field vectors of the permanent magnet 4 applied to the GMR elements 5a to 5d are the same as shown in Fig. 4B. Accordingly, the GMR elements can react to a magnetic field in which the number of the vector components horizontal to the forming surface where the GMR elements are formed is large, so that it is easy to ensure improved detection accuracy. That is, if the permanent magnet 4 further largely swings from the position shown by the two-dot chain line in Fig. 5, the magnetic field vectors of the permanent magnet 4 applied to the GMR elements are the same as shown in Fig. 4C. Accordingly, the GMR elements should be made to react to a magnetic field in which the number of the vector components horizontal to the forming surface where the GMR elements are formed is small, so that the switching device is easily affected by magnetic noise in this case.

In the swing type switching device having the above-described structure, if a user forces one side portion of the operating knob 3a in a state in which the operation body 3 is held at the neutral posture during the non-operation thereof, the operation body 3 is rotated in the clockwise direction, and if the one side portion is picked up by the finger or the like, the operation body 3 is rotated in the counterclockwise direction. Further, since the suspended piece 3b, which is a part of the operation body 3, is tilted due to the swing of the operation body 3, the permanent magnet 4 fixed to the suspended piece 3b swings (moves in a circular-arc shape) and thus the magnetic field of the permanent magnet 4 with respect to the GMR elements 5a to 5d is changed, and as a result, the output voltage of the GMR sensor 5 is changed. Accordingly, as described above, a plurality of swing positions of the operation body 3 can be detected on the basis of the output voltage and it is possible to perform the switching different for each swing position.

For example, in the case where the swing type switching device is a switching device for a power window of a vehicle, it is preferable that the switching for executing a manual-up operation of the window is performed when a voltage +E1 is output from the GMR sensor 5 (see Fig. 7). Likewise, it is preferable that the switching for executing an auto-up operation is performed when a voltage +E2 is output, the switching for executing a manual-down operation is performed when a voltage -E1 is output, and the switching for executing an auto-down operation is performed when a voltage -E2 is output, respectively.

In addition, in the above-described swing type switching device, if the operation body 3 swings, the suspended box portion 3c is tilted, so that the spherical body 8 moves along the cam face 10 for click. Furthermore, a click feeling is generated when the spherical body 8 climbs over a mountain portion of the cam face 10 for click. Further, since the click feeling is generated at the time that the operation body 3 is largely rotated from the neutral posture in the clockwise or counterclockwise direction and a voltage +E2 or -E2 is output from the GMR sensor 5, a user can clearly identify by the click feeling the switching that is different for different sizes of the rotation angle of the operation body 3.

As described above, in the swing type switching device according to this embodiment, when the permanent magnet 4 is positioned at the neutral position during the non-operation of the operation body 3, the direction of the magnetic field vectors of the permanent magnet 4 passing through the forming surface where the GMR elements 5a to 5d are formed is substantially parallel to the forming surface. Accordingly, even when the permanent magnet 4 has a normal magnetic force, it is possible to apply a strong magnetic field to each of the GMR elements. In addition, even when the permanent magnet 4 moves from the neutral position through the swing of the operation body 3, a magnetic field in which the number of the vector components parallel to the forming surface is large can be applied to each of the GMR elements since a movement range of the permanent magnet 4 is defined so that the height direction of the permanent magnet 4 is not largely tilted with respect to the forming surface where the GMR elements 5a to 5d are formed. Accordingly, it is possible to always efficiently apply the magnetic field of the permanent magnet 4 to the GMR elements 5a to 5d, the change of the magnetic field that is caused by the movement of the permanent magnet 4 can be easily and accurately detected by the GMR sensor 5, and thus the switching device is rarely affected by magnetic noise. As a result, it is possible to obtain the switching device which has high reliability. Moreover, since there is no need to use a special permanent magnet that has a strong magnetic force, component cost is easily suppressed.

Further, in the swing type switching device according to this embodiment, since the permanent magnet 4 is integrally formed with the operation body 3, the displacement of the permanent magnet 4 is easily made to exactly correspond to the swing position of the operation body 3 and the structure of the switching device is easily simplified. The permanent magnet may move by being driven by the operation body during the swing thereof. In this case, the permanent magnet may be driven by the operation body and slide in a straight line on a plane parallel to the rotation axis of the operation body.

Furthermore, in the above-described embodiment, the four GMR elements are used to detect the change of a magnetic field that is caused by the movement of the permanent magnet 4. However, the number of the GMR elements is not limited to four and it is possible not to use the GMR elements, but MREs as the magnetoresistive elements.

## Claims

1. A swing type switching device comprising:
an operation body (3) which can swing and automatically returns to a neutral posture during a non-operation;
a permanent magnet (4) which moves along a predetermined plane by being interlocked with the operation body (3) and is positioned at a neutral position during the non-operation of the operation body (3); and
a magnetoresistive element (5) of which the electrical resistance is changed in accordance with the change of a magnetic field that is caused by the movement of the permanent magnet (4),
wherein an operation position of the operation body (3) can be detected on the basis of the change of the resistance of the magnetoresistive element (5), and
wherein the permanent magnet (4) is magnetized so that pole faces (4a, 4b) thereof extend along the predetermined plane, and the magnetoresistive element (5) is formed in a plane that is substantially orthogonal to a height direction of the permanent magnet (4) positioned at the neutral position, and one pole face of the permanent magnet (4) is close to and faces a side portion of the magnetoresistive element (5) at the neutral position.

2. The swing type switching device according to Claim 1,
wherein the permanent magnet (4) swings along the predetermined plane by being interlocked with the operation body '(3).

3. The swing type switching device according to Claim 2,
wherein a swingable angle range of the permanent magnet (4) is defined so that a plane extended from a forming surface where the magnetoresistive element (5) is formed always crosses one pole face of the permanent magnet (4).

4. The swing type switching device according to Claim 2 or 3,
wherein a swingable angle range of the permanent magnet (4) is defined so that the magnetoresistive element (5) is positioned within a height range of the permanent magnet (4).

5. The swing type switching device according to any of Claims 1 to 4,
where the magnetoresistive element (5) is a giant magnetoresistance element.
